# EUROPEAN PATENT APPLICATION

(11) **EP 4 184 599 A1**
(43) Date of publication of application: **24.05.2023**
(21) Application number: 21842283.0
(22) Date of filing: 06.07.2021
(51) Int. Cl.: H01L 33/48, H01L 33/50, H01L 33/60, G09F 9/33

(54) **LIGHT-EMITTING DEVICE AND IMAGE DISPLAY DEVICE**

(30) Priority: 17.07.2020 JP 2020123307
(71) Applicant: Sony Group Corporation, Minato-Ku, Tokyo, 108-0075 (JP)
(72) Inventor: AKIBA, Akira, Tokyo 108-0075 (JP); KAJI, Tomohiro, Tokyo 108-0075 (JP); MORITA, Hiroki, Tokyo 108-0075 (JP); MAEDA, Yuki, Tokyo 108-0075 (JP); NISHI, Shota, Tokyo 108-0075 (JP); KOBAYASHI, Izushi, Tokyo 108-0075 (JP)
(74) Representative: D Young & Co LLP
(86) International application number: PCT/JP2021/025525
(87) International publication number: WO 2022/014421

(57) **Abstract**

A light-emitting device of an embodiment of the present disclosure includes: a support member having one surface; a light-emitting element provided on the one surface of the support member; a wavelength conversion section disposed in parallel with the light-emitting element on the one surface of the support member; and a light reflective member that is disposed to be opposed to the light-emitting element with the wavelength conversion section interposed therebetween, and forms a light reflective surface inclined relative to the one surface of the support member.

## Description

### Technical Field

The present disclosure relates to a light-emitting device having multiple light-emitting elements as a light source, and an image display apparatus including the light-emitting device.

### Background Art

For example, PTL 1 discloses that a wavelength conversion layer is disposed on a light output side above a light-emitting element in which an N-side layer, a light emission layer, and a P-side layer are stacked in this order.

### Citation List

### Patent Literature

PTL 1: Japanese Unexamined Patent Application Publication No. 2019-204823

### Summary of the Invention

Incidentally, a light-emitting device that wavelength-converts and extracts light emitted from a light-emitting element using quantum dots or the like is required to improve wavelength conversion efficiency.

It is desirable to provide a light-emitting device that makes it possible to improve wavelength conversion efficiency and an image display apparatus including the light-emitting device.

A light-emitting device of an embodiment of the present disclosure includes: a support member having one surface; a light-emitting element provided on the one surface of the support member; a wavelength conversion section disposed in parallel with the light-emitting element on the one surface of the support member; and a light reflective member that is disposed to be opposed to the light-emitting element with the wavelength conversion section interposed therebetween, and forms a light reflective surface inclined relative to the one surface of the support member.

An image display apparatus of an embodiment of the present disclosure includes the light-emitting device of the embodiment as one or multiple light-emitting devices.

In the light-emitting device of an embodiment of the present disclosure and the image display apparatus of an embodiment of the present disclosure, the light-emitting element and the wavelength conversion section are arranged in parallel, and further the light reflective member constituting the inclined light reflective surface is disposed to be opposed to the light-emitting element with the wavelength conversion section interposed therebetween. This ensures a length of an optical path of light emitted from the light-emitting element to pass through the wavelength conversion section.

### Brief Description of the Drawings

[FIG. 1] (A) of FIG. 1 is a schematic cross-sectional view of an example of a configuration of a light-emitting device according to an embodiment of the present disclosure, and (B) of FIG. 1 is a schematic plan view thereof.
[FIG. 2] FIG. 2 is a schematic cross-sectional view of an example of a configuration of a light-emitting element illustrated in FIG. 1.
[FIG. 3] FIG. 3 is a schematic plan view of another example of the configuration of the light-emitting device of the present disclosure.
[FIG. 4] FIG. 4 is a schematic plan view of another example of the configuration of the light-emitting device of the present disclosure.
[FIG. 5] FIG. 5 is a perspective view of an example of a configuration of a display apparatus including the light-emitting device of the present disclosure.
[FIG. 6] FIG. 6 is a schematic view of an example of a wiring layout of the image display apparatus illustrated in FIG. 5.
[FIG. 7] (A) of FIG. 7 is a schematic cross-sectional view of an example of a configuration of a light-emitting device according to Modification Example 1 of the present disclosure, and (B) of FIG. 7 is a schematic plan view thereof.
[FIG. 8] FIG. 8 is a schematic cross-sectional view of an example of a configuration of a light-emitting device according to Modification Example 2 of the present disclosure.
[FIG. 9] FIG. 9 is a schematic plan view of an example of a configuration of a light-emitting device according to Modification Example 3 of the present disclosure.
[FIG. 10] FIG. 10 is a schematic plan view of another example of the configuration of the light-emitting device according to Modification Example 3 of the present disclosure.
[FIG. 11] FIG. 11 is a schematic plan view of an example of a configuration of a light-emitting device according to Modification Example 4 of the present disclosure.
[FIG. 12] FIG. 12 is a schematic plan view of another example of the configuration of the light-emitting device according to Modification Example 4 of the present disclosure.
[FIG. 13] FIG. 13 is a schematic plan view of an example of a configuration of a light-emitting device according to Modification Example 5 of the present disclosure.
[FIG. 14] FIG. 14 is a schematic cross-sectional view of an example of a configuration of a light-emitting device according to Modification Example 6 of the present disclosure.
[FIG. 15] (A) of FIG. 15 is a schematic cross-sectional view of an example of a configuration of a light-emitting device according to Modification Example 7 of the present disclosure, and (B) of FIG. 15 is a schematic plan view thereof.
[FIG. 16] FIG. 16 is a schematic plan view of another example of the configuration of the light-emitting device according to Modification Example 7 of the present disclosure.
[FIG. 17] FIG. 17 is a perspective view of another example of the configuration of the display apparatus including the light-emitting device of the present disclosure.
[FIG. 18] FIG. 18 is a perspective view of a configuration of a mounting substrate illustrated in FIG. 17.
[FIG. 19] FIG. 19 is a perspective view of a configuration of a unit substrate illustrated in FIG. 18.

### Modes for Carrying Out the Invention

In the following, description is given in detail of embodiments of the present disclosure with reference to the drawings. The following description is merely a specific example of the present disclosure, and the present disclosure should not be limited to the following aspects. Moreover, the present disclosure is not limited to arrangements, dimensions, dimensional ratios, and the like of each component illustrated in the drawings. It is to be noted that the description is given in the following order.
1. Embodiment (An example of a light-emitting device in which a light-emitting element and a wavelength conversion section are arranged in parallel, and one side surface of a partition wall is served as an inclined light reflective surface)
   1-1. Configuring of Light-Emitting Device
   1-2. Configuration of Image Display Apparatus
   1-3. Workings and Effects
2. Modification Example 1 (An example of providing a wavelength conversion section and a light reflective surface on both sides with a light-emitting element interposed therebetween)
3. Modification Example 2 (An example of using a planar-type light-emitting element)
4. Modification Example 3 (An example of angling a partition wall between adjacent color pixels)
5. Modification Example 4 (An example in which an area of a wavelength conversion section is changed in response to wavelength conversion efficiency of quantum dots)
6. Modification Example 5 (An example of providing a wavelength conversion section across an entire outer periphery of a light-emitting element)
7. Modification Example 6 (An example of providing a heat dissipation section on a bottom surface of a wavelength conversion section and a side surface thereof in contact with a light reflective surface)
8. Modification Example 7 (An example of disposing multiple light-emitting elements for each of color pixels)
9. Modification Example 8 (Another example of an image display apparatus)

### <1. Embodiment>

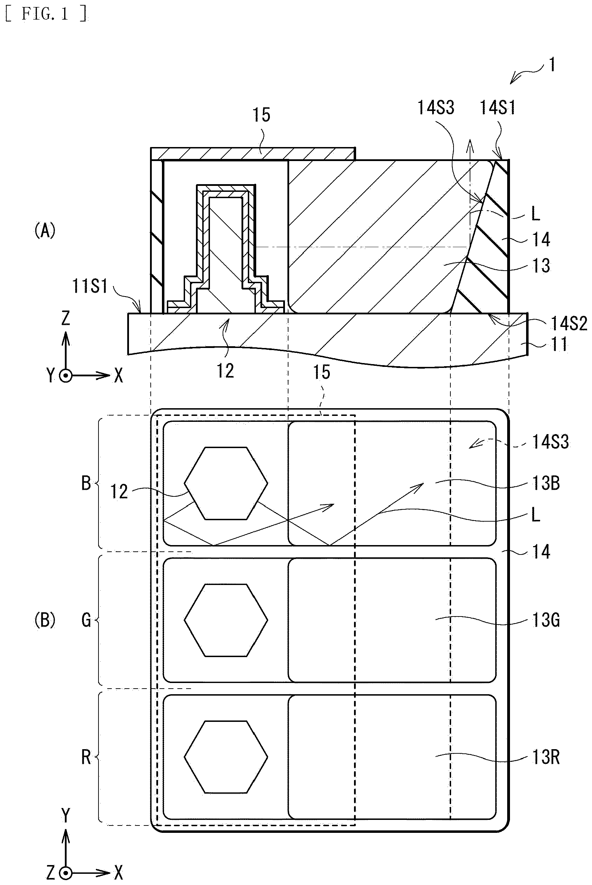

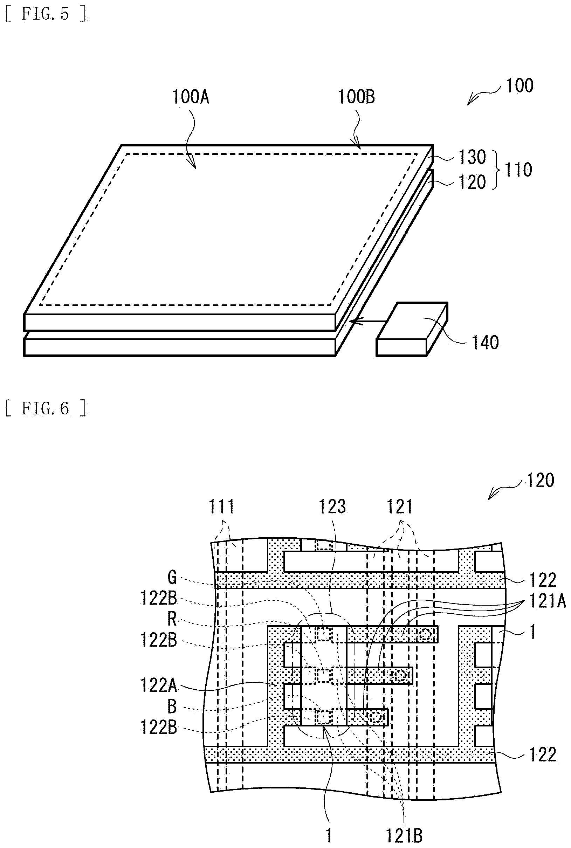

(A) of FIG. 1 schematically illustrates an example of a cross-sectional configuration of a light-emitting device (a light-emitting device 1) according to an embodiment of the present disclosure, and (B) of FIG. 1 schematically illustrates an example of a planar configuration thereof. The light-emitting device 1 is suitably applicable to each of color pixels corresponding to RGB constituting a display pixel of an image display apparatus (e.g., an image display apparatus 100, see FIG. 5) called a so-called LED display. In the light-emitting device 1 of the present embodiment, for example, a light-emitting element 12 and a wavelength conversion section 13 are arranged in parallel on a surface 11S1 of a support substrate 11, and further a light-reflective inclined surface 14S3 is disposed on the surface 11S1 of the support substrate 11 with the wavelength conversion section 13 interposed therebetween.

### (1-1. Configuration of Light-Emitting Device)

As described above, the light-emitting device 1 includes, for example, respective color pixels (a red pixel R, a green pixel G, and a blue pixel B) corresponding to, for example, RGB constituting a display pixel of the image display apparatus 100. The red pixel R, the green pixel G, and the blue pixel B each include, on the surface 11S1 of the support substrate 11, the light-emitting element 12 and the wavelength conversion section 13 (a red color conversion section 13R, a green color conversion section 13G, or a blue color conversion section 13B) corresponding to RGB. The red pixel R, the green pixel G, and the blue pixel B are separated from each other, for example by a partition wall 14. In the partition wall 14, a wall surface opposed to the light-emitting element 12 with the wavelength conversion section 13 interposed therebetween serves as the light-reflective inclined surface 14S3. Further, a light-blocking member 15 is disposed above the light-emitting element 12. Hereinafter, description is given of each of components of the light-emitting device 1.

The support substrate 11 is, for example, a silicon substrate in which an element drive circuit or the like of the light-emitting element 12 is produced.

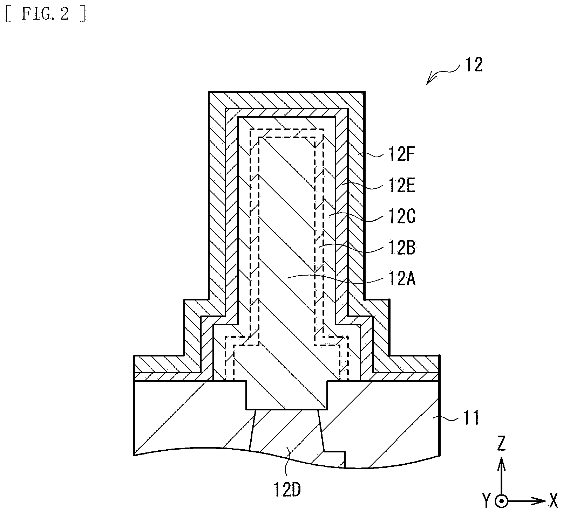

The light-emitting element 12 is, for example, a nano-column type or nano-wire type light-emitting diode (LED). FIG. 2 schematically illustrates an example of a cross-sectional configuration of the nano-column type light-emitting element 12. The light-emitting element 12 includes, for example, an n-type crystalline structure 12A, an active layer 12B, a p-type semiconductor layer 12C, an n-electrode 12D, and a p-electrode 12E.

The n-type crystalline structure 12A is formed by, for example, an n-type GaN-based semiconductor material. The n-type crystalline structure 12A is erected in a perpendicular direction (Z-axis direction) to the surface 11S1 of the support substrate 11 in a substantially hexagonal column shape, for example, as illustrated in FIGs. 1 and 2, and has a shape in which an area of a side surface thereof is larger than an area of a top surface thereof.

The active layer 12B is provided, for example, along the side surface and the top surface of the n-type crystalline structure 12A. The active layer 12B has, for example, a multiquantum well structure in which InGaN and GaN are alternately stacked, and has a light-emitting region in the layer. For example, the active layer 12B emits light in a blue region having an emission wavelength of 430 nm or more and 500 nm or less. In addition thereto, for example, the active layer 12B may emit light in an ultraviolet region having an emission wavelength of 350 nm or more and 430 nm or less.

The p-type semiconductor layer 12C is provided along a side surface and a top surface of the active layer 12B. The p-type semiconductor layer 12C is formed by, for example, a p-type GaN-based semiconductor material.

The n-electrode 12D is provided independently for each of the multiple light-emitting elements 12, and penetrates the support substrate 11 from a side of a surface opposed to the surface 11S1 of the support substrate 11, for example, to be in contact with the n-type crystalline structure 12A. The n-electrode 12D can be formed using, for example, a transparent electrode material such as ITO (Indiun Tin Oxide) or IZO (Indiun Zinc Oxide). In addition thereto, the n-electrode 12D may be formed using a metal material such as palladium (Pd), titanium (Ti), aluminum (Al), platinum (Pt), silver (Ag), nickel (Ni), or gold (Au).

The p-electrode 12E is provided to cover a periphery of the p-type semiconductor layer 12C. The p-electrode 12E is formed by, for example, a transparent electrode material such as ITO, IZO, tin oxide (SnO), or titanium oxide (TiO). The p-electrode 12E may be provided as a common layer for the multiple light-emitting elements 12, for example.

A passivation film 12F is further provided around the p-electrode 12E. The passivation film 12F is provided to protect a surface of the light-emitting element 12. The passivation film 12F is formed by, for example, silicon oxide (SiO), silicon nitride (SiN), or the like. In a case where the p-electrode 12E is provided as the common layer for the multiple light-emitting elements 12 as described above, for example, the passivation film 12F may be provided as a common layer for the multiple light-emitting elements 12, similarly to the p-electrode 12E.

The wavelength conversion section 13 (red color conversion section 13R, green color conversion section 13G, and blue color conversion section 13B) is provided to convert light emitted from the light-emitting element 12 provided in each of the red pixel R, the green pixel G, and the blue pixel B into a desired wavelength (e.g., red (R), green (G), or blue (B)) for emission.

The red color conversion section 13R, the green color conversion section 13G, and the blue color conversion section 13B include, for example, quantum dots corresponding to respective colors of R, G, and B. Specifically, in a case where red light is obtained, the quantum dots can be selected from InP, GaInP, InAsP, CdSe, CdZnSe, CdTeSe, CdTe, or the like, for example. In a case where green light is obtained, the quantum dots can be selected from InP, GaInP, ZnSeTe, ZnTe, CdSe, CdZnSe, CdS CdSeS, or the like, for example. In a case where blue light is obtained, the quantum dots can be selected from ZnSe, ZnTe, ZnSeTe, CdSe, CdZnSe, CdS, CdZnS, CdSeS, and the like. Among those described above, a cadmium (Cd)-free material is preferably used.

Quantum dot conversion efficiency has incident light intensity dependence and temperature dependence. In general, the quantum dot conversion efficiency has a tendency of simple reduction for any of them. Therefore, in a case where the same total amount of light is incident on the quantum dots, the efficiency in a high intensity range is greatly lowered when there is unevenness in the amount of light, thus causing total efficiency to also be lower than that at the time of average incidence. For this reason, as illustrated in FIG. 1, the wavelength conversion section 13 preferably has a curved surface at a lower part of a side surface thereof that is close to and faces the light-emitting element 12, and at an upper part and a lower part thereof that are in contact with the inclined surface 14S3 of the partition wall 14. This allows for reduction in an amount of incident light per unit area as well as suppression of a decrease in conversion efficiency. Such a shape can be formed by using, for example, isotropic etching, shadow mask lithography, or the like.

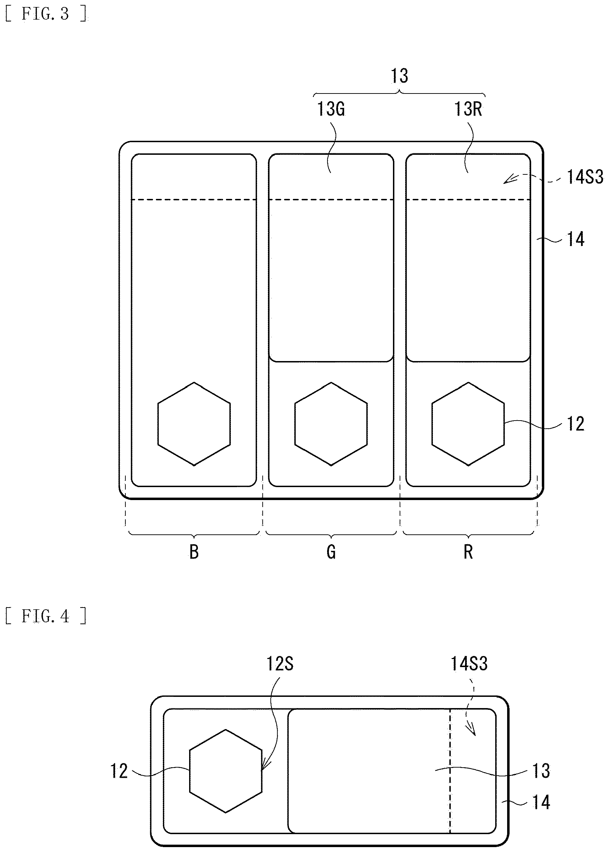

It is to be noted that, in a case where blue light is emitted from the light-emitting element 12, the blue color conversion section 13B of the blue pixel B may not be provided as illustrated in FIG. 3, for example. In addition, an angle of a growth substrate may be adjusted, for example, to thereby form the light-emitting element 12 erected in a substantially hexagonal column shape to allow one surface (e.g., a surface 12S) of the substantially hexagonal column-shaped light-emitting element 12 and a side surface of the wavelength conversion section 13 close to the light-emitting element 12 to face each other, for example, as illustrated in FIG. 4.

Further, an air layer may be present between the light-emitting element 12 and the wavelength conversion section 13; alternatively, a light-transmissive SiO film or resin layer may be embedded. In a case where a resin layer is embedded, a nano particle such as titanium oxide (TiO₂) may be dispersed as a scattering material in the resin layer.

The partition wall 14 partitions the red pixel R, the green pixel G, and the blue pixel B, and prevents color mixture between adjacent color pixels. The partition wall 14 forms, inside, for example, a substantially rectangular shaped space for each of the red pixel R, the green pixel G, and the blue pixel B, and the light-emitting element 12 and the wavelength conversion section 13 (red color conversion section 13R, green color conversion section 13G, or the blue color conversion section 13B) are provided in the inside space. Of four wall surfaces that constitute the space inside the partition wall 14, one wall surface opposed to the light-emitting element 12 with the wavelength conversion section 13 interposed therebetween serves as the inclined surface 14S3 that forms an angle of less than 90° relative to a bottom surface 14S2 of the partition wall 14. This inclined surface 14S3 corresponds to a specific example of a "light reflective surface" of the present disclosure, and the partition wall 14 part on which the inclined surface 14S3 is formed corresponds to a specific example of a "light reflective member" of the present disclosure. Another wall surface is erected substantially perpendicularly to the surface 11S1 of the support substrate 11.

The partition wall 14 is formed, for example, using a light-reflective metal material such as aluminum (Al), silver (Ag), and rhodium (Rh). In addition thereto, the partition wall 14 may be formed to have a shape of the partition wall 14 illustrated in FIG. 1 by etching a silicon substrate, for example, and a surface thereof may be coated with a metal film such as Al for formation. This enables the partition wall 14 to be formed with good compatibility with a large-diameter silicon step.

The light-blocking member 15 is provided to prevent zero-th order light emitted from the light-emitting element 12 from being extracted from the light-emitting device 1, and is disposed above the light-emitting element 12. The light-blocking member 15 is supported, for example, by a top surface 14S1 of the partition wall 14, and extends to a portion of the wavelength conversion section 13. The light-blocking member 15 preferably has light reflectivity similarly to the partition wall 14, for example, in addition to a light-blocking property, and can be formed, for example, using a metal material such as Al, Ag, and Rh. This allows light emitted upward from the light-emitting element 12 to be reflected by the light-blocking member 15, thus improving efficiency of guiding light emitted from the light-emitting element 12. This light-blocking member 15 corresponds to a specific example of a "light reflective film" of the present disclosure.

It is to be noted that providing a light reflective film on a lower surface of the light-blocking member 15 (surface opposed to the light-emitting element 12) also enables achievement of similar effects. In addition thereto, the light-blocking member 15 may also be formed using, for example, a dichroic mirror that selectively reflects light of a wavelength emitted from the light-emitting element 12.

As illustrated in (A) and (B) of FIG. 1, with the above-described configuration, light L emitted from the light-emitting element 12 is directly incident on or reflected by the wall surface of the partition wall 14 to be incident on the wavelength conversion section 13, is converted into a desired wavelength, and is then emitted from a top surface of the wavelength conversion section 13 where no light-blocking member 15 is formed.

### (1-2. Configuration of Image Display Apparatus)

FIG. 5 is a perspective view of an example of an outline configuration of an image display apparatus (image display apparatus 100) of the present disclosure. The image display apparatus 100 is called a so-called LED display, and uses the light-emitting device 1 of the present embodiment for a display pixel. As illustrated in FIG. 5, for example, the image display apparatus 100 includes a display panel 110 and a control circuit 140 that drives the display panel 110.

The display panel 110 includes a mounting substrate 120 and a counter substrate 130 which are overlapped each other. The counter substrate 130 has a surface serving as a picture display surface, and has a display region 100A at a middle portion thereof as well as a frame region 100B being a non-display region around the display region 100A.

FIG. 6 illustrates an example of a wiring layout of a region, corresponding to the display region 100A, of a surface of the mounting substrate 120 on a side of the counter substrate 130. In the region, corresponding to the display region 100A, of the surface of the mounting substrate 120, for example, as illustrated in FIG. 6, multiple data wiring lines 121 are formed to extend in a predetermined direction, and are arranged in parallel at a predetermined pitch. In the region, corresponding to the display region 100A, of the surface of the mounting substrate 120, for example, multiple scan wiring lines 122 are further formed to extend in a direction intersecting (e.g., orthogonal to) the data wiring lines 121, and are arranged in parallel at a predetermined pitch. The data wiring line 121 and the scan wiring line 122 each include, for example, an electrically-conductive material such as Cu (copper).

The scan wiring lines 122 are formed on, for example, an uppermost layer, and is formed on, for example, an insulating layer (unillustrated) formed on a surface of a base material. It is to be noted that a base material of the mounting substrate 120 includes, for example, a silicon substrate, a resin substrate, or the like, and that the insulating layer on the base material includes, for example, silicon nitride (SiN), silicon oxide (SiO), aluminum oxide (AlO), or a resin material. Meanwhile, the data wiring lines 121 are formed inside a layer different from the uppermost layer including the scan wiring lines 122 (e.g., a layer under the uppermost layer), and is formed, for example, inside the insulating layer on the base material.

A periphery of an intersecting portion of the data wiring line 121 and the scan wiring line 122 corresponds to the display pixel 123, and multiple display pixels 123 are arranged in a matrix shape within the display region 100A. Each of the display pixels 123 is mounted with the light-emitting device 1 including color pixels (red pixel R, green pixel G, and blue pixel B) corresponding to RGB, for example. It is to be noted that FIG. 6 exemplifies a case where three color pixels (red pixel R, green pixel G, and blue pixel B) constitute one display pixel 123 to enable the red pixel R, the green pixel G, and the blue pixel B to output red light, green light, and blue light, respectively.

The light-emitting device 1 is provided with, for example, a pair of terminal electrodes disposed for each of the red pixel R, the green pixel G, and the blue pixel B, or provided with terminal electrodes one of which is shared by the red pixel R, the green pixel G, and the blue pixel B and another of which is disposed for each of the red pixel R, the green pixel G, and the blue pixel B. In addition, the one of the terminal electrodes is electrically coupled to the data wiring line 121, and the other of the terminal electrodes is electrically coupled to the scan wiring line 122. For example, the one of the terminal electrodes is electrically coupled to a pad electrode 121B at the tip of a branch 121A provided in the data wiring line 121. Further, for example, the other of the terminal electrodes is electrically coupled to a pad electrode 122B at the tip of a branch 122A provided in the scan wiring line 122.

Each of the pad electrodes 121B and 122B is formed, for example, in the uppermost layer, and is provided, for example, at a location where each light-emitting device 1 is mounted, as illustrated in FIG. 6. Here, the pad electrodes 121B and 122B each include, for example, an electrically-conductive material such as Au (gold).

The mounting substrate 120 is further provided with, for example, multiple support columns (unillustrated) to regulate an interval between the mounting substrate 120 and the counter substrate 130. The support column may be provided within a region facing the display region 100A, or may be provided within a region facing the frame region 100B.

The counter substrate 130 includes, for example, a glass substrate, a resin substrate, or the like. A surface of the counter substrate 130 on a side of the light-emitting device 1 may be planar, but is preferably a rough surface. The rough surface may be provided across the entire region facing the display region 100A, or may be provided only in a region facing the display pixel 123. The rough surface has fine unevenness on which light beams emitted from the red pixel R, the green pixel G, and the blue pixel B are incident on the rough surface. The unevenness of the rough surface can be prepared by, for example, sandblasting, dry etching, or the like.

The control circuit 140 drives each display pixel 123 (each light-emitting device 1) on the basis of a picture signal. The control circuit 140 is configured by, for example, a data driver that drives the data wiring lines 121 coupled to the display pixel 123 and a scan driver that drives the scan wiring lines 122 coupled to the display pixel 123. For example, as illustrated in FIG. 5, the control circuit 140 may be provided separately from the display panel 110 and coupled to the mounting substrate 120 via a wiring line, or may be mounted on the mounting substrate 120.

### (1-3. Workings and Effects)

In the light-emitting device 1 of the present embodiment, the light-emitting element 12 and the wavelength conversion section 13 are arranged in parallel on the surface 11S1 of the support substrate 11, and further the light-reflective inclined surface 14S3 is disposed on the surface 11S1 of the support substrate 11 with the wavelength conversion section 13 interposed therebetween. This ensures a length of an optical path of light emitted from the light-emitting element 12 to pass through the wavelength conversion section 13. This is described hereinafter.

As described above, in the image display apparatus in which so-called micro LEDs are used as a light source, the wavelength conversion layer including, for example, quantum dots is disposed above each of the micro LEDs, and an image display element is used that extracts, as each color light beam of RGB, light converted into a desired wavelength by passing through the wavelength conversion layer.

However, in the image display element having such a structure, it is generally difficult to wavelength-convert light (excitation light) emitted from the micro LED highly efficiently in the wavelength conversion layer, causing issues such as color shift, a decrease in luminance, and heat generation. Incidentally, for example, the color shift is caused by leakage of blue light, for example, emitted as excitation light from the micro LED without being converted by the wavelength conversion layer. In addition, the color shift is caused by a lack of a red light component and a green light component due to low wavelength conversion efficiency of quantum dots corresponding to a red color and a green color, respectively. The lowered luminance is caused by adjustment of white balance between color pixels with different wavelength conversion efficiencies as well as different light extraction efficiencies associated therewith, and by a luminosity factor, or the like. The heat generation is caused by processing of a blue light component, for example, which is unnecessary for the purpose of the adjustment of the white balance.

This issue is able to be solved, for example, by increasing a thickness of the wavelength conversion layer to ensure a length of an optical path that contributes to the conversion efficiency. However, the increased thickness of the wavelength conversion layer causes issues such as an increase in a difficulty level of steps for forming the wavelength conversion layer and an increase in a working difficulty level due to an increase in an aspect ratio of a pixel separation layer that separates adjacent wavelength conversion layers from each other. In addition, the increased thickness of the wavelength conversion layer is disadvantageous to miniaturization of a display pixel. These issues are particularly important in a self-luminous type micro display using the micro LEDs.

In contrast, in the light-emitting device 1 of the present embodiment, the light-emitting element 12 and the wavelength conversion section 13 are arranged in parallel, and the light-reflective inclined surface 14S3 is provided on a side of a rear surface (a surface opposed to the side surface facing the light-emitting element 12) of the wavelength conversion section 13. This allow light emitted from the light-emitting element 12 and wavelength-converted by the wavelength conversion section 13 to be extracted from the light-emitting device 1. This makes it possible to ensure a length of an optical path of light (excitation light) emitted from the light-emitting element 12 and passing through the wavelength conversion section 13.

As described above, it is possible, in the light-emitting device 1 of the present embodiment, to sufficiently and easily ensure a length of an optical path of light (excitation light) emitted from the light-emitting element 12 and passing through the wavelength conversion section 13, as compared with the case where the wavelength conversion layer is disposed above the light-emitting element 12, thus making it possible to improve the wavelength conversion efficiency in the wavelength conversion section 13.

In addition, in the light-emitting device 1 of the present embodiment, the light-emitting element 12 and the wavelength conversion section 13 are arranged in parallel, thus making it possible to reduce the height of the light-emitting device 1.

In particular, application of the light-emitting device 1 of the present embodiment as a display pixel of a self-luminous type micro display makes it possible to implement a micro display having superior display quality in which color shift, reduction in luminance, heat generation, and the like are improved.

Next, description is given of modification examples (Modification Examples 1 to 8) of the present disclosure. Hereinafter, components similar to those of the foregoing first embodiment are denoted by the same reference numerals, and descriptions thereof are omitted as appropriate.

### <2. Modification Example 1>

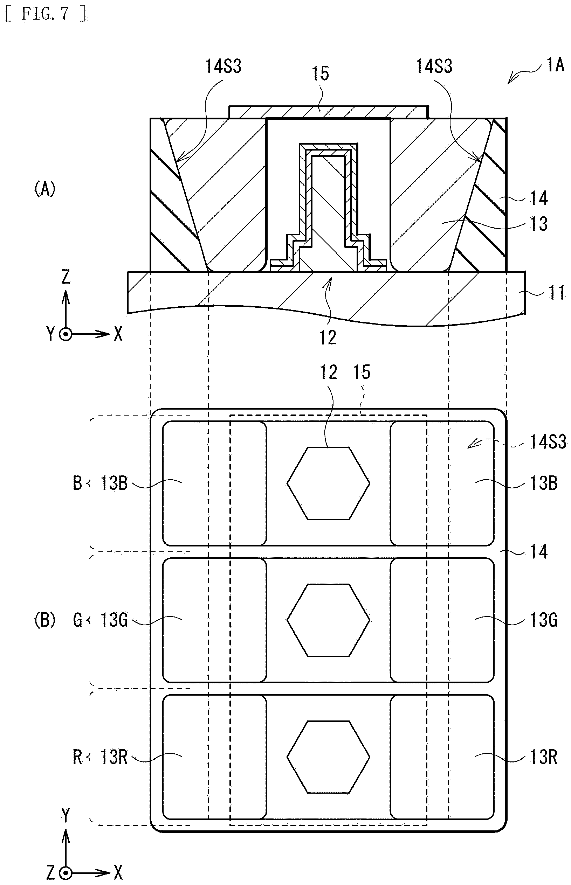

(A) of FIG. 7 schematically illustrates an example of a cross-sectional configuration of a light-emitting device (a light-emitting device 1A) according to Modification Example 1 of the present disclosure, and (B) of FIG. 1 schematically illustrates an example of a planar configuration thereof. The light-emitting device 1A of the present modification example differs from the foregoing embodiment in that, for example, the light-emitting element 12 is disposed, for example, in the middle of a space inside the partition wall 14 having a substantially rectangular shape, and the wavelength conversion section 13 and the light-reflective inclined surface 14S3 are provided on both sides with the light-emitting element 12 interposed therebetween.

In this manner, in the present modification example, the wavelength conversion section 13 and the inclined surface 14S3 are provided on both sides of the light-emitting element 12, thus making it possible to reduce the number of reflections of light (excitation light) emitted from the light-emitting element 12 reflected at the wall surface of the partition wall 14 until the light is incident on the wavelength conversion section 13. Thus, it is possible to improve use efficiency of the light emitted from the light-emitting element 12 as compared with the foregoing embodiment.

### <3. Modification Example 2>

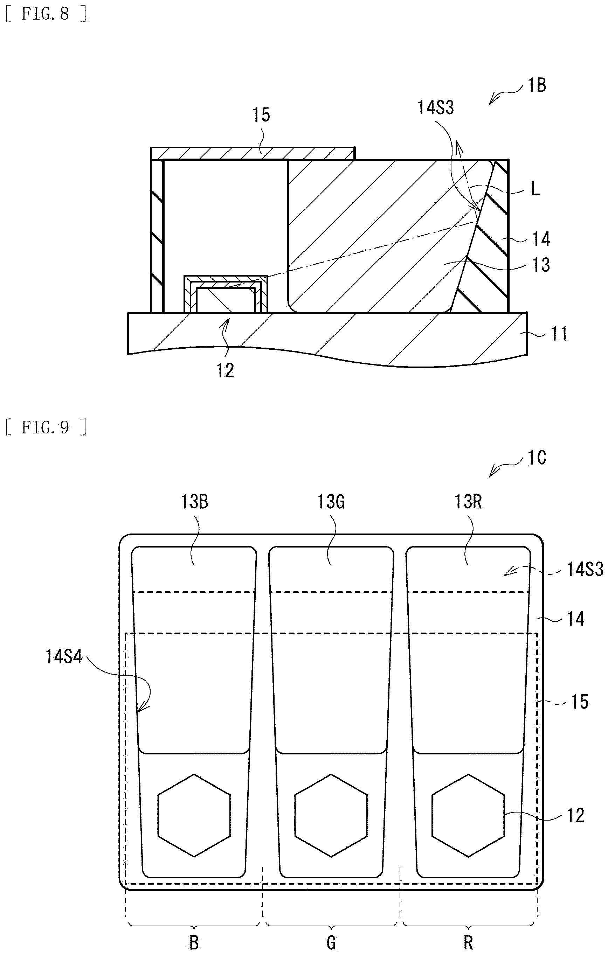

FIG. 8 schematically illustrates an example of a cross-sectional configuration of a light-emitting device (a light-emitting device 1B) according to Modification Example 2 of the present disclosure. The foregoing embodiment and the like have given the example in which the nano-column type or nano-wire type light-emitting diode (LED) is used as the light-emitting element 12. However, for example, as illustrated in FIG. 8, the present technology is effective, also in a case where a planar-type LED having an active layer only on a surface parallel to the surface 11S1 of the support substrate 11, for example, is used for the light-emitting element 12; it is possible to obtain effects similar to those of the foregoing embodiment.

### <4. Modification Example 3>

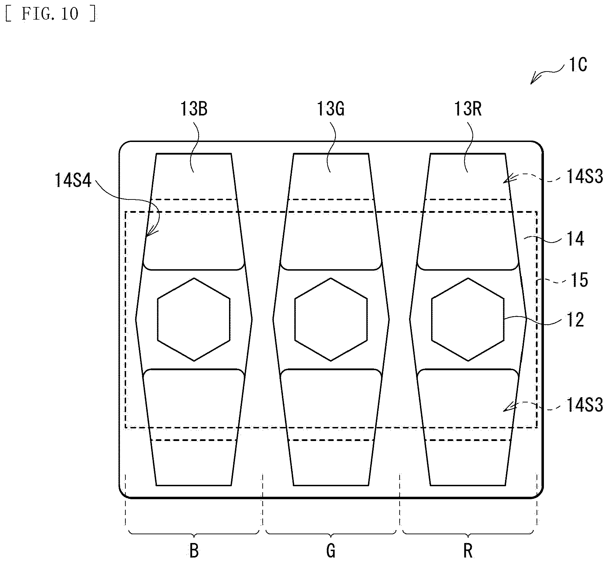

FIGs. 9 and 10 each schematically illustrate an example of a planar configuration of a light-emitting device (a light-emitting device 1C) according to Modification Example 3 of the present disclosure. The foregoing embodiment has given the example in which the opposing wall surfaces 14S4 of the partition wall 14 separating the adjacent red pixel R, green pixel G, and blue pixel B from each other are substantially parallel to each other; however, this is not limitative.

For example, as illustrated in FIG. 9, the wall surface 14S4 of the partition wall 14 may have a substantially trapezoidal shape in a plan view to allow, for example, a width between the opposing wall surfaces 14S4 to be gradually widened from a side where the light-emitting element 12 is disposed toward a side of the inclined surface 14S3. In addition, in a case where the wavelength conversion section 13 and the inclined surface 1453 are provided on both sides with the light-emitting element 12 interposed therebetween as described in the foregoing Modification Example 1, as illustrated in FIG. 10, the wall surface 14S4 of the partition wall 14 may have a substantially hexagonal shape in a plan view to allow, for example, the width between the opposing wall surfaces 14S4 to be gradually narrowed from the middle of the wall surface 14C4 where the light-emitting element 12 is disposed toward the side of the inclined surface 14S3.

In this manner, angling the opposing wall surfaces 14S4 of the partition wall 14 allows light reflected by the wall surface 14S4 to be efficiently reflected to the wavelength conversion section 13. Thus, it is possible to further improve use efficiency of the light emitted from the light-emitting element 12, in addition to the effects of the foregoing embodiment, and the like.

### <5. Modification Example 4>

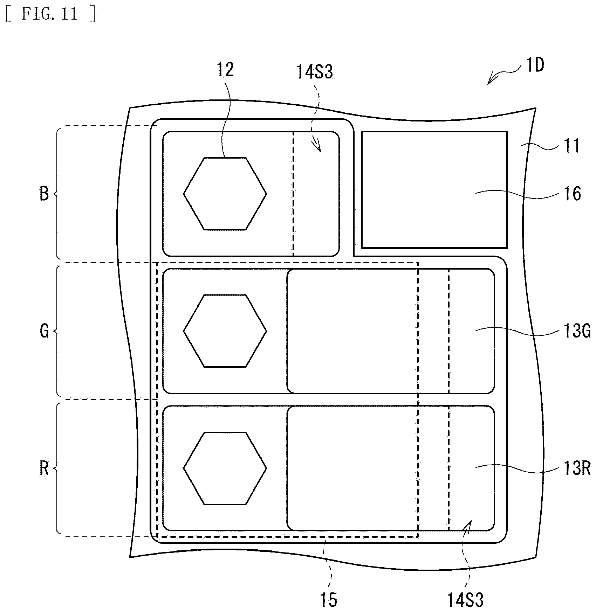

FIG. 11 schematically illustrates an example of a planar configuration of a light-emitting device (a light-emitting device 1D) according to Modification Example 4 of the present disclosure. The foregoing embodiment has given the example in which the red pixel R, the green pixel G, and the blue pixel B have substantially the same area; however, this is not limitative. For example, the areas of the red pixel R, the green pixel G, and the blue pixel B may be areas corresponding to wavelength conversion efficiencies of the respective wavelength conversion sections 13 (red color conversion section 13R, green color conversion section 13G, and the blue color conversion section 13B).

Specifically, as described above, in a case where the light-emitting element 12 emitting blue light is used, light emitted from the light-emitting element 12 can be used as it is in the blue pixel B, and thus the blue color conversion section 13B can be omitted. In that case, for example, as illustrated in FIG. 11, the area of the blue pixel B can be made smaller than those of the red pixel R and the green pixel G, and thus, for example, a circuit 16 or the like can be provided in the empty space.

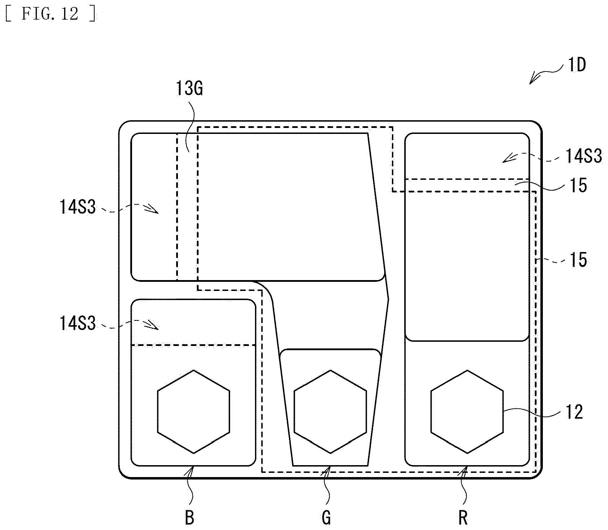

In addition, in general, quantum dots corresponding to a green color have lower wavelength conversion efficiency than that of quantum dots corresponding to a red color. Therefore, for example, as illustrated in FIG. 12, the green pixel G may be extended in the reduced space of the blue pixel B to secure a length of an optical path of light passing through the inside of the green color conversion section 13G. This makes it possible to improve the wavelength conversion efficiency in the green pixel G. Thus, it is possible to improve use efficiency of light beams in the red pixel R, the green pixel G, and the blue pixel B and to improve luminance.

### <6. Modification Example 5>

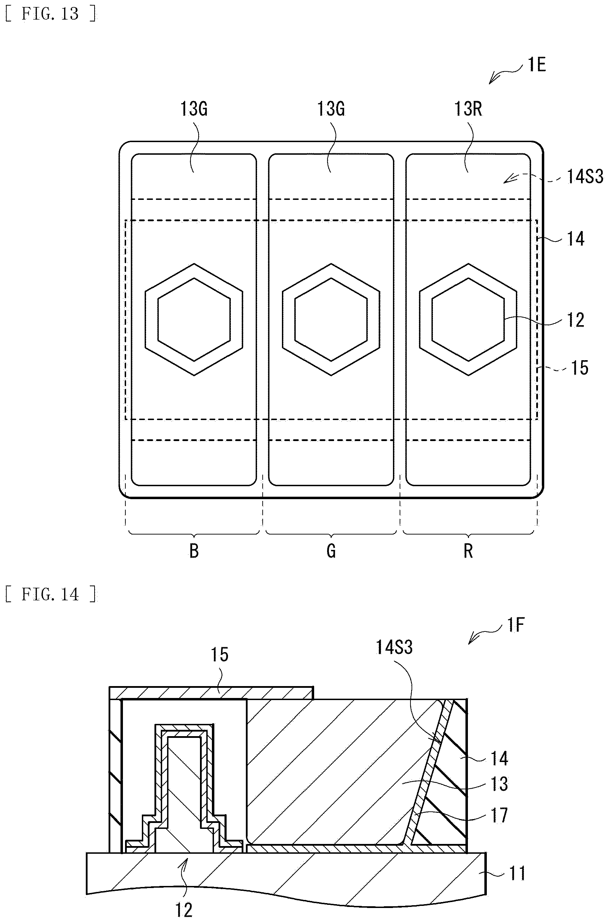

FIG. 13 schematically illustrates an example of a planar configuration of a light-emitting device (a light-emitting device 1E) according to Modification Example 5 of the present disclosure. The present modification example differs from the foregoing embodiment in that, for example, the wavelength conversion section 13 is provided across the entire outer periphery of the nano-column type light-emitting element 12.

In this manner, providing the wavelength conversion section 13 across the entire outer periphery of the light-emitting element 12 makes it possible to further ensure a length of an optical path of light passing through the inside of the wavelength conversion section 13. This makes it possible to further improve the wavelength conversion efficiency as compared with the foregoing embodiment.

### <7. Modification Example 6>

FIG. 14 schematically illustrates an example of a cross-sectional configuration of a light-emitting device (a light-emitting device 1F) according to Modification Example 6 of the present disclosure. The present modification example differs from the foregoing embodiment in that a heat dissipation section 17 is provided across a bottom surface of the wavelength conversion section 13 and a side surface thereof in contact with the inclined surface 14S3.

The heat dissipation section 17 dissipates heat generated at the time of wavelength conversion to reduce temperature rise in the wavelength conversion section 13. The heat dissipation section 17 is preferably formed by, for example, a light-reflective metal film such as Al to ensure light reflectivity on the inclined surface 14S3. This heat dissipation section 17 corresponds to a specific example of a "heat dissipation member" of the present disclosure.

In this manner, in the present modification example, the heat dissipation section 17 is provided across the bottom surface of the wavelength conversion section 13 and the side surface thereof in contact with the inclined surface 14S3. This allows for reduction in the temperature rise in the wavelength conversion section 13 due to heat generated at the time of wavelength conversion as well as suppression of a decrease in the wavelength conversion efficiency of quantum dots constituting the wavelength conversion section 13. Thus, it is possible to further improve the wavelength conversion efficiency as compared with the foregoing embodiment.

### <8. Modification Example 7>

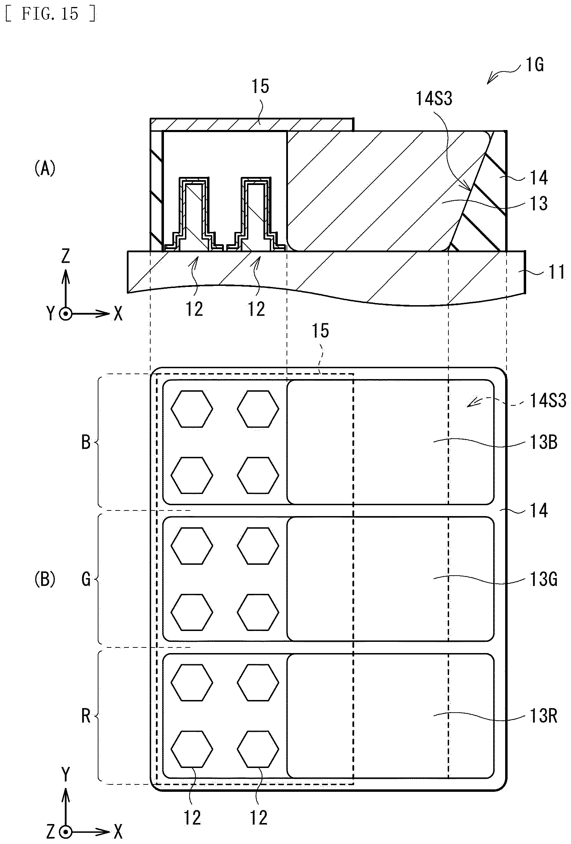

(A) of FIG. 15 schematically illustrates an example of a cross-sectional configuration of a light-emitting device (a light-emitting device 1G) according to Modification Example 7 of the present disclosure, and (B) of FIG. 15 schematically illustrates an example of a planar configuration thereof. The present modification example differs from the foregoing embodiment in that multiple (four in this example) light-emitting elements 12 are provided for each of the red pixel R, the green pixel G, and the blue pixel B.

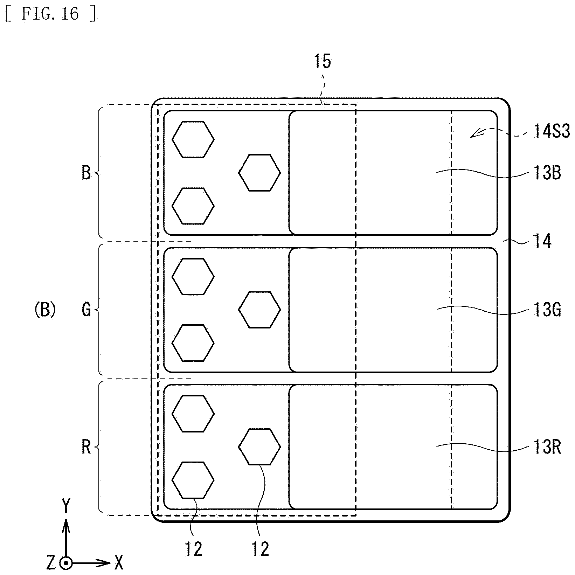

It is to be noted that, although FIG. 15 illustrates the example in which four light-emitting elements 12 are arranged in two rows by two columns, the arrangement example of the multiple light-emitting elements 12 is not limited thereto. For example, as illustrated in FIG. 16, for example, three light-emitting elements 12 may be arranged alternately.

In this manner, each of the color pixels (red pixel R, green pixel G, and blue pixel B) may be provided with the multiple light-emitting elements 12. This makes it possible to further reduce the height of the light-emitting device 1 as compared with the case where one light-emitting element 12 is provided. In addition, incident light rays to the wavelength conversion section 13 are homogenized as compared with the case where one light-emitting element 12 is provided, thus making it possible to further improve the wavelength conversion efficiency. Additionally, it is possible to reduce heat generation in the wavelength conversion section 13.

### <9. Modification Example 8>

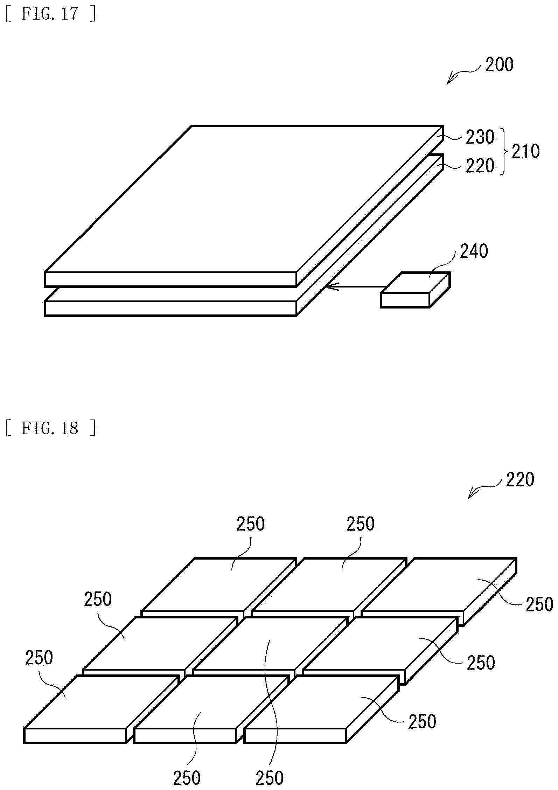

FIG. 17 is a perspective view of another configuration example (an image display apparatus 200) of the display image apparatus using the light-emitting device (e.g., light-emitting device 1) of the present disclosure. The image display apparatus 200 is called a so-called tiling display in which an LED is used as a light source, and the light-emitting device 1 of the present embodiment is used as a display pixel. For example, as illustrated in FIG. 17, the image display apparatus 200 includes a display panel 210 and a control circuit 240 that drives the display panel 210.

The display panel 210 includes a mounting substrate 220 and a counter substrate 230 which are overlapped each other. The counter substrate 230 has a surface serving as a picture display surface, and has a display region at a middle portion thereof as well as a frame region being a non-display region around the display region (none of which is illustrated). For example, the counter substrate 230 is disposed at a position facing the mounting substrate 220 with a predetermined gap interposed therebetween. It is to be noted that the counter substrate 230 may be in contact with a top surface of the mounting substrate 220.

FIG. 18 schematically illustrates an example of a configuration of the mounting substrate 220. For example, as illustrated in FIG. 18, the mounting substrate 220 is configured by multiple unit substrates 250 laid in a tile shape. It is to be noted that FIG. 18 illustrates the example in which the mounting substrate 220 is configured by nine unit substrates 250; however, the number of the unit substrates 250 may be ten or more, or may be eight or less.

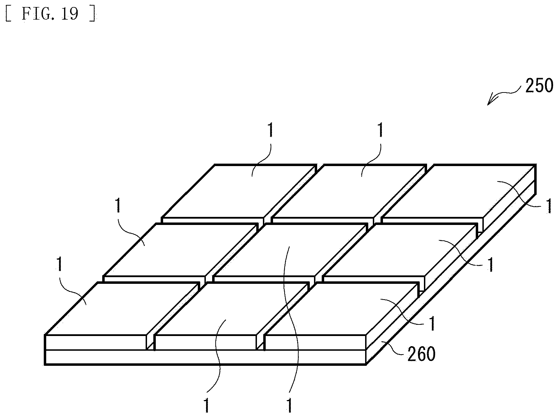

FIG. 19 illustrates an example of a configuration of the unit substrate 250. The unit substrate 250 includes, for example, the light-emitting devices 1 including multiple red pixels R, green pixels G, and blue pixels B laid in a tile shape, and a support substrate 260 that supports the respective light-emitting devices 1. Each of the unit substrates 250 further includes a control substrate (unillustrated). The support substrate 260 is configured by, for example, a metal frame (metal plate), a wiring substrate, or the like. In a case where the support substrate 260 is configured by a wiring substrate, it may also be possible for the support substrate 260 to serve as a control substrate. At this time, at least one of the support substrate 260 or the control substrate is electrically coupled to each of the light-emitting devices 1.

Description has been given hereinabove of the present disclosure referring to the embodiment and Modification Example 1 to 8; however, the present disclosure is not limited to the foregoing embodiment, and may be modified in a wide variety of ways. For example, the components, the arrangement, the number, and the like of the light-emitting element 12 exemplified in the foregoing embodiment, and the like are merely exemplary. All of the components need not be included, and other components may further be included.

In addition, as for the foregoing Modification Examples 1 to 8, respective configurations can be combined with one another. For example, Modification Examples 1 and 3 to 7 have given the example in which the nano-column type light-emitting element 12 is used; however, it is possible to obtain similar effects also in a case where the planar-type light-emitting element 12 as exhibited in Modification Example 2 is used.

Further, the foregoing embodiment and the like have given the examples in which the light-emitting device 1 or the like is applied to the image display apparatus 100, 200, or the like; however, the light-emitting device 1 or the like of the present disclosure can also be used as an illumination apparatus.

It is to be noted that the effects described herein are merely exemplary and are not limited thereto, and may further include other effects.

The present technology may also have the following configurations. According to the present technology of the following configurations, the light-emitting element and the wavelength conversion section are arranged in parallel, and further the light reflective member constituting the inclined light reflective surface is disposed to be opposed to the light-emitting element with the wavelength conversion section interposed therebetween. This ensures a length of an optical path of light emitted from the light-emitting element to pass through the wavelength conversion section. Thus, it is possible to improve the wavelength conversion efficiency.
(1) A light-emitting device including:
   a support member having one surface;
   a light-emitting element provided on the one surface of the support member;
   a wavelength conversion section disposed in parallel with the light-emitting element on the one surface of the support member; and
   a light reflective member disposed to be opposed to the light-emitting element with the wavelength conversion section interposed therebetween, the light reflective member forming a light reflective surface inclined relative to the one surface of the support member.
(2) The light-emitting device according to (1), further including a light reflective film above the light-emitting element.
(3) The light-emitting device according to (2), in which the light reflective film extends from above the light-emitting element to a portion of the wavelength conversion section.
(4) The light-emitting device according to any one of (1) to (3), in which the wavelength conversion section and the light reflective member are each disposed on both sides with the light-emitting element interposed therebetween.
(5) The light-emitting device according to any one of (1) to (4), further including a partition wall disposed on the one surface of the support member and surrounding a periphery of the light-emitting element.
(6) The light-emitting device according to (5), in which at least a portion of a wall surface of the partition wall constitutes the light reflective member.
(7) The light-emitting device according to (5) or (6), in which
   the light-emitting element includes multiple light-emitting elements, which are provided on the one surface of the support member, and
   the multiple light-emitting elements are separated from each other by the partition wall.
(8) The light-emitting device according to (7), in which the wall surface of the partition wall provided between the multiple light-emitting elements is provided vertically to the one surface of the support member.
(9) The light-emitting device according to any one of (1) to (8), including multiple color pixels corresponding to a red color, a green color, and a blue color, in which
   the light-emitting element is provided for each of the multiple color pixels.
(10) The light-emitting device according to (9), in which
   red light and green light emitted via the wavelength conversion section are extracted, respectively, in the color pixel corresponding to the red color and the color pixel corresponding to the green color, and
   light emitted from the light-emitting element is extracted directly as blue light without going through the wavelength conversion section in the color pixel corresponding to the blue color.
(11) The light-emitting device according to any one of (1) to (10), in which the wavelength conversion section is provided across an entire outer periphery of the light-emitting element in a plan view.
(12) The light-emitting device according to any one of (1) to (11), further including a heat dissipation member provided between the wavelength conversion section and the support member and between the wavelength conversion section and the light reflective member.
(13) The light-emitting device according to any one of (1) to (12), in which the light-emitting element includes a light-emitting diode having a nano-column structure or a nano-wire structure.
(14) The light-emitting device according to any one of (1) to (13), in which the wavelength conversion section includes a quantum dot.
(15) The light-emitting device according to (14), in which the quantum dot includes a cadmium-free quantum dot.
(16) The light-emitting device according to any one of (2) to (15), in which the light reflective film is formed using a metal film or a dichroic mirror.
(17) An image display apparatus including one or multiple light-emitting devices,
   the light-emitting devices each including
   a support member having one surface,
   a light-emitting element provided on the one surface of the support member,
   a wavelength conversion section disposed in parallel with the light-emitting element on the one surface of the support member, and
   a light reflective member disposed to be opposed to the light-emitting element with the wavelength conversion section interposed therebetween, the light reflective member forming a light reflective surface inclined relative to the one surface of the support member.

This application claims the benefit of Japanese Priority Patent Application JP 2020-123307 filed with the Japan Patent Office on July 17, 2020, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. A light-emitting device comprising:
a support member having one surface;
a light-emitting element provided on the one surface of the support member;
a wavelength conversion section disposed in parallel with the light-emitting element on the one surface of the support member; and
a light reflective member disposed to be opposed to the light-emitting element with the wavelength conversion section interposed therebetween, the light reflective member forming a light reflective surface inclined relative to the one surface of the support member.

2. The light-emitting device according to claim 1, further comprising a light reflective film above the light-emitting element.

3. The light-emitting device according to claim 2, wherein the light reflective film extends from above the light-emitting element to a portion of the wavelength conversion section.

4. The light-emitting device according to claim 1, wherein the wavelength conversion section and the light reflective member are each disposed on both sides with the light-emitting element interposed therebetween.

5. The light-emitting device according to claim 1, further comprising a partition wall disposed on the one surface of the support member and surrounding a periphery of the light-emitting element.

6. The light-emitting device according to claim 5, wherein at least a portion of a wall surface of the partition wall constitutes the light reflective member.

7. The light-emitting device according to claim 5, wherein
the light-emitting element comprises multiple light-emitting elements, which are provided on the one surface of the support member, and
the multiple light-emitting elements are separated from each other by the partition wall.

8. The light-emitting device according to claim 7, wherein a wall surface of the partition wall provided between the multiple light-emitting elements is provided vertically to the one surface of the support member.

9. The light-emitting device according to claim 1, comprising multiple color pixels corresponding to a red color, a green color, and a blue color, wherein
the light-emitting element is provided for each of the multiple color pixels.

10. The light-emitting device according to claim 9, wherein
red light and green light emitted via the wavelength conversion section are extracted, respectively, in the color pixel corresponding to the red color and the color pixel corresponding to the green color, and
light emitted from the light-emitting element is extracted directly as blue light without going through the wavelength conversion section in the color pixel corresponding to the blue color.

11. The light-emitting device according to claim 1, wherein the wavelength conversion section is provided across an entire outer periphery of the light-emitting element in a plan view.

12. The light-emitting device according to claim 1, further comprising a heat dissipation member provided between the wavelength conversion section and the support member and between the wavelength conversion section and the light reflective member.

13. The light-emitting device according to claim 1, wherein the light-emitting element comprises a light-emitting diode having a nano-column structure or a nano-wire structure.

14. The light-emitting device according to claim 1, wherein the wavelength conversion section includes a quantum dot.

15. The light-emitting device according to claim 14, wherein the quantum dot comprises a cadmium-free quantum dot.

16. The light-emitting device according to claim 2, wherein the light reflective film is formed using a metal film or a dichroic mirror.

17. An image display apparatus comprising one or multiple light-emitting devices,
the light-emitting devices each including
a support member having one surface,
a light-emitting element provided on the one surface of the support member,
a wavelength conversion section disposed in parallel with the light-emitting element on the one surface of the support member, and
a light reflective member disposed to be opposed to the light-emitting element with the wavelength conversion section interposed therebetween, the light reflective member forming a light reflective surface inclined relative to the one surface of the support member.
